# EUROPÄISCHE PATENTSCHRIFT

(11) **EP 3 103 581 B1**
(45) Veröffentlichungstag und Bekanntmachung des Hinweises auf die Patenterteilung: **30.10.2019**
(21) Anmeldenummer: 15405038.9
(22) Anmeldetag: 11.06.2015
(51) Int. Cl.: B23Q 1/44, B23Q 1/60, G12B 5/00, H01L 21/68

(54) **POSITIONIERVORRICHTUNG**
POSITIONING DEVICE
DISPOSITIF DE POSITIONNEMENT

(43) Veröffentlichungstag der Anmeldung: 14.12.2016
(60) Teilanmeldung: 16185431.0
(73) Patentinhaber: Schneeberger Holding AG, 4914 Roggwil (CH)
(72) Erfinder: Krauer, Patrick, 6017 Ruswil (CH)
(74) Vertreter: EGLI-EUROPEAN PATENT ATTORNEYS

(56) Entgegenhaltungen:
- EP-A1- 1 911 551
- DE-A1- 3 725 188
- JP-A- 2000 153 994
- JP-U- S6 175 935

## Beschreibung

Die Erfindung betrifft eine Positioniervorrichtung gemäss dem Oberbegriff des Anspruchs 1, die ein Basiselement und ein Trägerelement umfasst, das entlang einer z-Achse relativ zum Basiselement durch Verschieben wenigstens zweier Schiebeelemente quer zur z-Achse positionierbar ist.

Eine derartige Positioniervorrichtung ist beispielsweise aus US 005731631 A bekannt. Die dort beschriebene Vorrichtung umfasst eine Basis sowie ein Trägerelement mit einer Arbeitsfläche und zwei der Arbeitsfläche gegenüberliegenden, parallel verlaufenden Keilflächen. Das Trägerelement ist über zwei voneinander beabstandeten vertikalen Linearführungen mit der Basis verbunden, welche die Bewegung des Trägerelements relativ zur Basis auf eine Verschiebung entlang der vertikalen z-Achse einschränken. Die Positioniervorrichtung umfasst ferner als Schiebeelement zwei starr miteinander verbundene, parallel verlaufende Keile, die zwischen jeweils einer der Keilflächen des Trägerelements und der Basis angeordnet und über zwei voneinander beabstandeten Linearführungen mit der Basis verbunden sind. Mittels der beiden Linearführungen sind die Keile entlang einer x-Achse senkrecht zur z-Achse bewegbar. Zudem sind die Oberseiten der Keile jeweils über eine weitere Linearführung mit den Keilflächen des Trägerelements verschiebbar verbunden. Ein Linearmotor dient zum Bewegen der Keile längs der x-Achse, wodurch das Trägerelement entlang der z-Achse relativ zur Basis bewegt wird. Dabei verhindern die beiden vertikalen Linearführungen zwischen der Basis und dem Trägerelement, dass sich das Trägerelement bei der Bewegung längs der z-Achse zudem auch längs der x-Achse relativ zur Basis mitbewegt.

Für viele Anwendungen im Bereich der Hochpräzisionspositionierung reicht die Systemsteifigkeit derartiger Positioniervorrichtungen mit vertikalen Linearführungen jedoch häufig nicht aus. Insbesondere gewährleistet eine vertikale Linearführung keine hinreichend grosse Rotationssteifigkeit um die vertikale Achse. Ausserdem ist eine Konstruktion mit Verschiebekeilen und zusätzlichen vertikalen Linearführungen technisch wie wirtschaftlich sehr aufwendig.

Ferner ist aus EP 1 911 551 A1 eine Positioniervorrichtung mit zwei parallelen Linearverschiebeaktuatoren bekannt, die jeweils über zwei parallel ausgerichtete, schräge Anlaufflächen mit einem zu verschiebenden Trägerelement gekoppelt sind. Die beiden Anlaufflächen sind in ihrer Neigung einander entgegengesetzt angeordnet, sodass eine synchronentgegengesetzte Bewegung beider Aktuator-Achsen ein Heben oder Senken des Trägerelements bewirkt. Die beiden schrägen Anlaufflächen sind durch entsprechend schräg angeordnete Linearführungsschienen gebildet, die an gegenüberliegenden Seiten des Trägerelements angeordnet sind. Die Verwendung von zwei parallelen Linearverschiebeaktuatoren macht die Vorrichtung jedoch technisch wie wirtschaftlich sehr aufwendig und erfordert insbesondere eine Synchronisation beider Antriebe.

Aufgabe der vorliegenden Erfindung ist es daher, die aus dem Stand der Technik bekannten Positioniervorrichtungen mit Schiebeelementen einerseits technisch zu vereinfachen und andererseits hinsichtlich ihrer Systemsteifigkeit zu verbessern.

Diese Aufgabe wird durch eine Positioniervorrichtung gemäss Anspruch 1 gelöst. Vorteilhafte Ausführungsformen der Erfindung sind Gegenstand der abhängigen Ansprüche.

Die Positioniervorrichtung umfasst ein Basiselement, ein relativ zum Basiselement entlang einer z-Achse zu positionierendes Trägerelement sowie wenigstens ein erstes und ein zweites Schiebeelement, wobei das erste bzw. zweite Schiebeelement einerseits mittels einer ersten bzw. zweiten Basis-Führungseinrichtung entlang einer ersten bzw. zweiten Basislinie am Basiselement und andererseits mittels einer ersten bzw. zweiten Steig-Führungseinrichtung entlang einer ersten bzw. zweiten Steiglinie an dem Trägerelement verschiebbar angeordnet ist. Dabei verlaufen die erste bzw. zweite Steiglinie und die erste bzw. zweite Basislinie in Projektion entlang der z-Achse zueinander parallel und bezüglich der z-Achse mit jeweils konstanten, voneinander verschiedenen Neigungswinkeln. Die Steiglinien bzw. Basislinien entsprechen dabei den Führungsbahnen bzw. Verschiebewegen der jeweiligen Steig- bzw. Basis-Führungseinrichtungen.

Gemäss der Erfindung ist es vorgesehen, dass die erste und die zweite Steig-Führungseinrichtung derart zueinander angeordnet sind, dass in wenigstens einer Projektion senkrecht zur z-Achse die erste und die zweite Steiglinie bezüglich der z-Achse gegenläufig zueinander geneigt sind.

Es wurde erkannt, dass eine derartig gegenläufige Anordnung der ersten und zweiten Steig-Führungseinrichtung bewirkt, dass durch eine synchrone Verschiebung des ersten und des zweiten Schiebeelements relativ zum Basiselement entlang der Basis-Führungseinrichtungen das Trägerelement relativ zum Basiselement ausschliesslich entlang der z-Achse verschoben und damit verhindert wird, dass sich das Trägerelement quer zur z-Achse mitbewegt. Denn aufgrund ihrer gegenläufigen Neigungen sperren die erste und die zweite Steig-Führungseinrichtung jeweils gegenseitig eine Querbewegung des Trägerelements entlang der ersten bzw. zweiten Basis-Führungsrichtung bzw. Basislinie. Daher kann auf eine zusätzliche vertikale Führung, die die Bewegung des Trägerelements auf die z-Achse beschränkt, verzichtet werden. Darüber hinaus wurde in erfindungsgemässer Weise erkannt, dass die gegenläufige Anordnung zusätzlich eine für Hochpräzisionsanwendungen hinreichende Systemsteifigkeit gewährleistet.

"Synchrone Verschiebung der Schiebeelemente" im Sinne dieser Erfindung bedeutet, dass die jeweiligen Verschiebebewegungen des ersten und des zweiten Schiebeelements entlang der ersten bzw. zweiten Basislinie in Abhängigkeit der Neigungen der ersten bzw. zweiten Steiglinie gegenüber der z-Achse derart aufeinander abgestimmt sind, dass das erste und das zweite Schiebeelement bei der Synchronverschiebung entlang der ersten bzw. zweiten Basislinie das Trägerelement entlang der z-Achse um den gleichen Betrag verschieben.

Um die Systemsteifigkeit, insbesondere die Rotationssteifigkeit, der Positioniervorrichtung zu erhöhen, ist es gemäss der Erfindung vorgesehen, dass die Positioniervorrichtung ferner ein drittes und ein viertes Schiebeelement aufweist. Dabei ist das dritte bzw. vierte Schiebeelement einerseits mittels einer dritten bzw. vierten Basis-Führungseinrichtung entlang einer dritten bzw. vierten Basislinie am Basiselement und andererseits mittels einer dritten bzw. vierten Steig-Führungseinrichtung entlang einer dritten bzw. vierten Steiglinie an dem Trägerelement verschiebbar angeordnet. Die dritte bzw. vierte Steiglinie und die dritte bzw. vierte Basislinie verlaufen in einer Projektion entlang der z-Achse zueinander parallel und bezüglich der z-Achse mit jeweils konstanten, voneinander verschiedenen Neigungswinkeln. Zudem sind die dritte und vierte Steig-Führungseinrichtung derart zueinander angeordnet, dass in wenigstens einer Projektion senkrecht zur z-Achse die dritte und die vierte Steiglinie bezüglich der z-Achse gegenläufig zueinander geneigt sind, so dass eine synchrone Verschiebung des ersten, zweiten, dritten und vierten Schiebeelements relativ zum Basiselement eine Verschiebung des Trägerelements relativ zum Basiselement ausschliesslich entlang der z-Achse bewirkt.

Anstelle von zwei oder vier Schiebeelementen sind grundsätzlich auch andere Anzahlen von derartigen Schiebeelementen mit gegenseitiger Sperrwirkung denkbar, die eine Bewegung des Trägerelements auf eine Verschiebung entlang der z-Achse einschränken. So können beispielsweise drei, fünf oder mehr Schiebeelemente in eine Polygon-Konfiguration gleichmässig verteilt um die z-Achse angeordnet sein. Bevorzugt sind jedoch jeweils Paare von Schiebeelementen mit gegenseitiger Sperrwirkung vorhanden, die so zueinander angeordnet sind, dass in wenigstens einer Projektion senkrecht zur z-Achse beide Steiglinien des jeweiligen Paares bezüglich der z-Achse gegenläufig zueinander geneigt sind.

Gemäss einer weiteren vorteilhaften Ausführungsform der Erfindung verlaufen die erste und/oder zweite Basislinie bzw. die erste, zweite, dritte und/oder vierte Basislinie in einer Ebene senkrecht zur z-Achse. Ferner kann es vorgesehen sein, dass die erste und zweite Basislinie bzw. die erste, zweite, dritte und vierte Basislinie gleichmässig um die z-Achse verteilt angeordnet sind. Alternativ oder zusätzlich können die erste und zweite Basislinie bzw. die erste, zweite, dritte und vierte Basislinie bezüglich der z-Achse achsensymmetrisch ausgebildet sein. Denkbar ist ferner, dass die erste und zweite Steiglinie bzw. die erste, zweite, dritte und vierte Steiglinie bezüglich der z-Achse achsensymmetrisch ausgebildet sind. Durch diese Massnahmen vereinfacht sich insbesondere die technische Komplexität des Aufbaus der Positioniervorrichtung. Zudem vereinfacht sich die Synchronisierung der Verschiebebewegungen der Schiebeelemente entlang der Basislinien.

Die Basisführungseinrichtungen bzw. die Basislinien können grundsätzlich jede beliebige Form aufweisen, wobei sie entlang der z-Achse nicht gekrümmt sind, sondern einen konstanten Neigungswinkel gegenüber der Z-Achse grösser 0° und kleiner 180° aufweisen. Gleiches gilt für die Steig-Führungseinrichtungen bzw. die Steiglinien, wobei sich der Neigungswinkel der Steig-Führungseinrichtungen bzw. Steiglinien vom Neigungswinkel der jeweils korrespondierenden Basis-Führungseinrichtungen bzw. Basislinien unterscheidet. Denkbar sind beispielsweise Basis-Führungseinrichtungen, die in einer Ebene senkrecht zur z-Achse angeordnet sind und einen gekrümmten Verlauf in der Ebene aufweisen. Besonders bevorzugt sind jedoch die Basis- und/oder Steig-Führungseinrichtungen als Linearführungen ausgebildet. So ist es gemäss einer vorteilhaften Ausführungsform der Erfindung vorgesehen, dass die erste und zweite Basislinie Geraden sind, insbesondere parallel zueinander entlang einer zur z-Achse senkrechten x-Achse verlaufen. Bei einer Ausführungsform mit insgesamt vier Schiebeelementen kann ferner vorgesehen sein, dass auch die dritte und vierte Basislinie Geraden sind, die insbesondere parallel zueinander entlang einer zur x- und z-Achse senkrechten y-Achse verlaufen.

Sofern die Basislinien Geraden sind, d.h. die Basis-Führungseinrichtungen als Linearführungen ausgebildet sind, ist es zwangsläufig so, dass bei einer solchen Ausführungsform auch die jeweils korrespondierenden Steiglinien Geraden sind bzw. die jeweils korrespondierenden Steig-Führungseinrichtungen als Linearführungen ausgebildet sind, da gemäss der Erfindung die Steiglinien in einer Projektion entlang der z-Achse parallel zu den jeweils korrespondierenden Basis-Basislinien verlaufen.

Gemäss einer weiteren vorteilhaften Ausführungsform der Erfindung ist es vorgesehen, dass die erste, zweite, dritte und/oder vierte Basis-Führungseinrichtung eine Kugellager-, Kreuzrollenlager-, Umwälzlager- oder Schwalbenschwanz-Führung aufweist. Zusätzlich oder alternativ kann es vorgesehen sein, dass die erste, zweite, dritte und/oder vierte Steig-Führungseinrichtung eine Kugellager-, Kreuzrollenlager-, Umwälzlager- oder Schwalbenschwanz-Führung aufweist.

Um die unterschiedlichen Neigungswinkel der jeweils korrespondierenden Basis- und Steiglinien zu realisieren, kann es gemäss einer weiteren vorteilhaften Ausführungsform der Erfindung vorgesehen sein, dass das erste, zweite, dritte und/oder vierte Schiebeelement jeweils einen Keilkörper aufweist, an dem vorzugsweise die entsprechenden Basis-Führungseinrichtungen und Steig-Führungseinrichtungen an gegenüberliegenden, auseinanderlaufenden Seiten des Keilkörpers angeordnet sind, wobei der Öffnungswinkel des Keils dem Differenzwinkel zwischen dem Neigungswinkel der Basislinie und dem Neigungswinkel der korrespondierenden Steiglinie relativ zur z-Achse entspricht.

In analoger Weise kann es vorgesehen sein, dass das Trägerelement einen ersten, zweiten, dritten und/oder vierten Keilkörper aufweist, an dem jeweils die erste, zweite, dritte bzw. vierte Steig-Führungseinrichtung angeordnet ist. Denkbar ist auch, dass das Trägerelement eine erste, zweite, dritte und/oder vierte Schrägfläche aufweist, an dem jeweils die erste, zweite, dritte bzw. vierte Steig-Führungseinrichtung angeordnet ist.

Über die Wahl des Neigungswinkel der jeweiligen Steiglinie und korrespondierenden Basislinie kann die Übersetzung zwischen der Verschiebebewegung des Schiebeelements entlang der Basislinie und der daraus resultierenden Verschiebebewegung des Trägerelements entlang der z-Achse eingestellt werden. Bei einer besonders bevorzugten Ausführungsform schliessen die erste, zweite, dritte und vierte Steiglinie zur z-Achse jeweils einen Winkel zwischen 45° und 85°, insbesondere zwischen 60° und 80°, bevorzugt zwischen 71° und 79°, ein.

Bei einer weiteren bevorzugten Ausführungsform der Erfindung weist das Basiselement eine Platte, insbesondere eine rahmenartige Platte mit einer Durchgangsöffnung, auf. In analoger Weise kann es vorgesehen sein, dass das Trägerelement einen Rahmen, insbesondere einen rechteckigen, bevorzugt quadratischen Rahmen, aufweist. Durch diese Konstruktion ergibt sich eine besonders starre Positioniervorrichtung mit einer hohen Systemsteifigkeit.

Im Sinne einer sehr kompakten Bauweise der Positionierungsvorrichtung kann es ferner vorgesehen sein, dass die erste und die zweite Steig-Führungseinrichtung an gegenüberliegenden Seiten des Trägerelements angeordnet sind, und/oder dass die dritte und die vierte Steig-Führungseinrichtung an gegenüberliegenden Seiten des Trägerelements angeordnet sind.

Zum synchronen Verschieben des ersten und zweiten Schiebeelements bzw. des ersten, zweiten, dritten und vierten Schiebeelements kann die Positioniervorrichtung gemäss einer weiteren Ausgestaltung der Erfindung wenigstens eine Antriebseinrichtung, insbesondere eine gemeinsame Antriebseinrichtung für alle Schiebeelemente, oder jeweils eine separate Antriebseinrichtung für das erste und zweite Schiebeelement bzw. das erste, zweite, dritte und vierte Schiebeelement aufweisen.

Als Antriebseinrichtung sind jegliche Arten von Antrieben denkbar, beispielsweise Linear-Aktuatoren oder Dreh-Aktuatoren, Piezo-Aktuatoren, Spindelantriebe, Linearmotoren, Steppmotoren, Servo-Motoren oder dergleichen.

Gemäss einer besonders bevorzugten Ausführungsform der Erfindung ist es vorgesehen, dass die wenigstens eine Antriebseinrichtung einen Drehantrieb mit einer zur z-Achse parallelen Drehachse sowie ein Koppelelement aufweist, wobei das Koppelelement den Drehantrieb mit dem ersten, zweiten, dritten und/oder vierten Schiebeelement derart koppelt, dass eine Drehbewegung des Drehantriebs eine synchrone Verschiebung des ersten und zweiten Verschiebeelemets bzw. des ersten, zweiten, dritten und vierten Schiebeelements entlang der jeweiligen Basislinien bewirkt. Hierzu kann es vorgesehen sein, dass das Koppelelement einen starr mit der Drehachse verbundenen Drehkörper und wenigstens ein Koppelglied aufweist, das bezüglich der Drehachse einen Ends an einem der Schiebeelemente und anderen Ends radial, beabstandet von der Drehachse an dem Drehkörper drehbar gelagert ist.

Weitere Ziele, Vorteile und Anwendungsmöglichkeiten der vorliegenden Erfindung ergeben sich aus der nachfolgenden Beschreibung eines in den Zeichnungen dargestellten Ausführungsbeispiels der Erfindung.

Es zeigen:
- Fig. 1: eine perspektivische Ansicht eines möglichen Ausführungsbeispiels einer erfindungsgemässen Positioniervorrichtung;
- Fig. 2: Explosionsdarstellung der Positioniervorrichtung gemäss Fig. 1;
- Fig. 3: Draufsicht auf die Positioniervorrichtung gemäss Fig. 1;
- Fig. 4: Querschnitt durch die Positioniervorrichtung gemäss Fig. 1 entlang der z-Achse; und
- Fig. 5: Seitenansicht der Positioniervorrichtung gemäss Fig. 1 entlang der y-Achse.

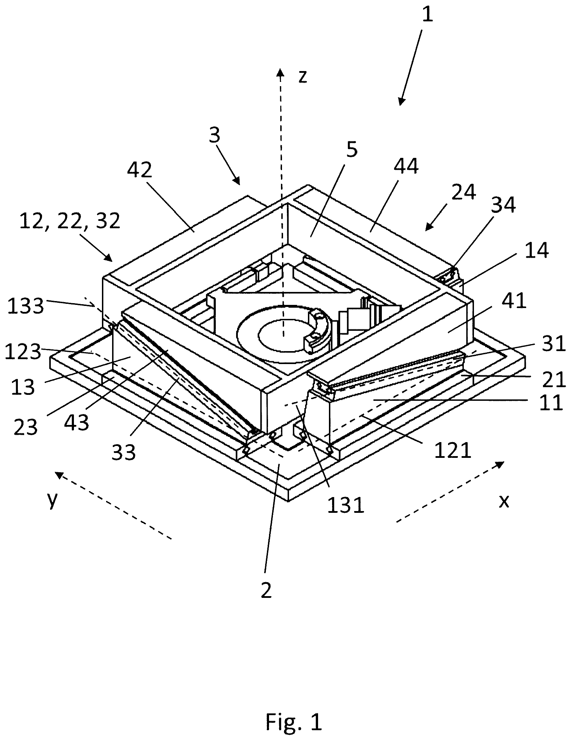

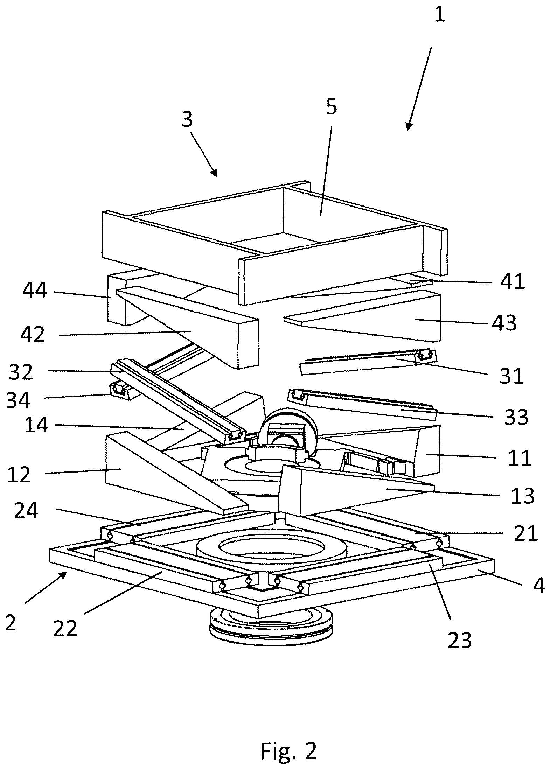

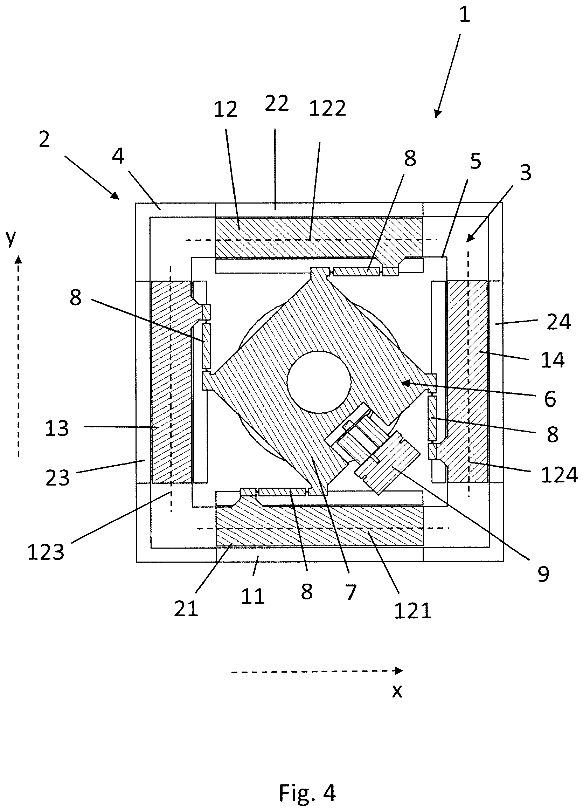

Die Fig. 1 bis 5 zeigen ein mögliches Ausführungsbeispiel einer erfindungsgemässen Positioniervorrichtung 1. Die Positioniervorrichtung 1 weist ein flaches, als rahmenartige Platte 4 mit Durchgangsöffnung ausgebildetes Basiselement 2 sowie ein relativ zum Basiselement 2 entlang einer z-Achse zu positionierendes Trägerelement 3 auf, das ebenfalls in Form eines quadratischen Rahmens 5 ausgebildet ist.

Zum Verschieben des Trägerelements 3 entlang der z-Achse weist die Positioniervorrichtung 1 ferner ein erstes, ein zweites, ein drittes und ein viertes Schiebeelement 11, 12, 13, 14 auf. Die vier Schiebeelemente 11, 12, 13, 14 sind dabei in einer gemeinsamen Ebene senkrecht zur z-Achse sowie in einer Rechteck-Konfiguration gleichmässig um die z-Achse verteilt zwischen dem Trägerelement 3 und dem Basiselement 2 verschiebbar angeordnet.

An dem ersten, zweiten, dritten und vierten Schiebeelement 11, 12, 13, 14 ist jeweils eine erste, zweite, dritte bzw. vierte Basis-Führungseinrichtung 21, 22, 23, 24 und eine erste, zweite, dritte bzw. vierte Steig-Führungseinrichtung 31, 32, 33, 34 angeordnet.

Mittels der ersten bzw. zweiten Basis-Führungseinrichtung 21, 22 ist das erste bzw. zweite Schiebeelement 11, 12 entlang einer ersten bzw. zweiten Basislinie 121, 122, die entlang einer senkrecht zur z-Achse ausgerichteten x-Achse verläuft, relativ zum Basiselement 2 verschiebbar. Entsprechend ist das dritte bzw. vierte Schiebeelement 13, 14 entlang einer dritten bzw. vierten Basislinie 123, 124, die entlang einer zur x- und z-Achse senkrecht ausgerichteten y-Achse verläuft, mittels einer dritten bzw. vierten Basis-Führungseinrichtung 23, 24 linear verschiebbar an dem Bandelement 2 angeordnet.

Die jeweiligen Basis-Führungseinrichtungen 21, 22, 23, 24 sind jeweils an einer Basisseite der als Keilkörper ausgebildeten Schiebeelemente 11, 12, 13, 14 angeordnet. An der der jeweiligen Basisseite gegenüberliegenden Schrägseite der keilartigen Schiebeelemente 11, 12, 13, 14 sind die jeweiligen Steig-Führungseinrichtungen 31, 32, 33, 34 angeordnet, mittels denen die Schiebeelemente 11, 12, 13, 14 entlang einer ersten, zweiten, dritten bzw. vierten Steiglinie 131, 132, 133, 134 linear verschiebbar an korrespondierenden Schrägflächen des Trägerelementes 3 angebunden sind.

Die Schrägseiten am Trägerelement 3, an denen jeweils die erste, zweite, dritte bzw. vierte Steig-Führungseinrichtung 31, 32, 33, 34 angeordnet ist, werden jeweils durch einen ersten, zweiten, dritten bzw. vierten Keilkörper 41, 42, 43, 44 gebildet. Diese Keilkörper 41, 42, 43, 44 sind korrespondierend zu den keilartigen Schiebeelementen 11, 12, 13, 14 in einer Rechteck-Konfiguration gleichmässig um die z-Achse verteilt an den Aussenseiten des rahmenartigen Trägerelementes 3 angeordnet. Zur besseren Anbindung der Keilkörper an den Rahmen 5 des Trägerelementes 3 stehen die vier Wandelemente, aus denen der Rahmen 5 aufgebaut ist, jeweils an einer Ecke des Rahmens über, sodass die Keilkörper 41, 42, 43, 44 jeweils an zwei rechtwinklig zueinander angeordneten Wandflächen des Rahmens 5 anliegen. Hierdurch wird die Systemsteifigkeit der Positioniervorrichtung 1 mitunter zusätzlich erhöht.

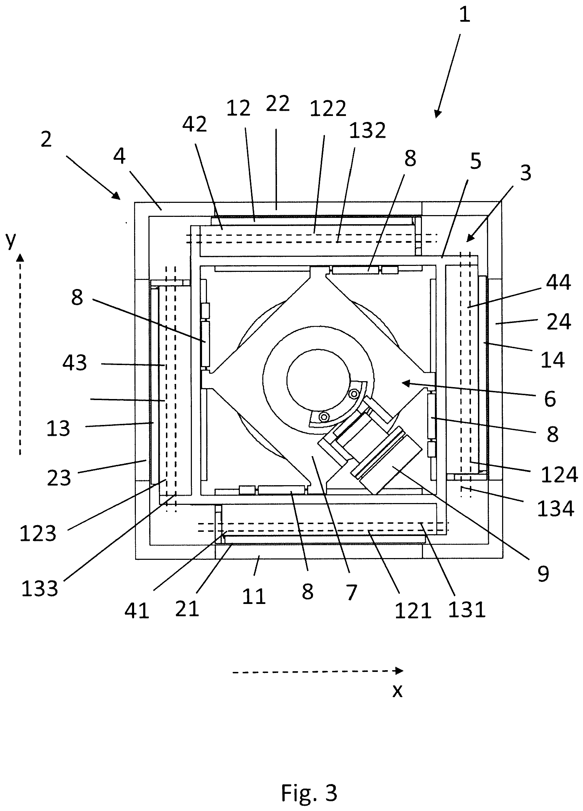

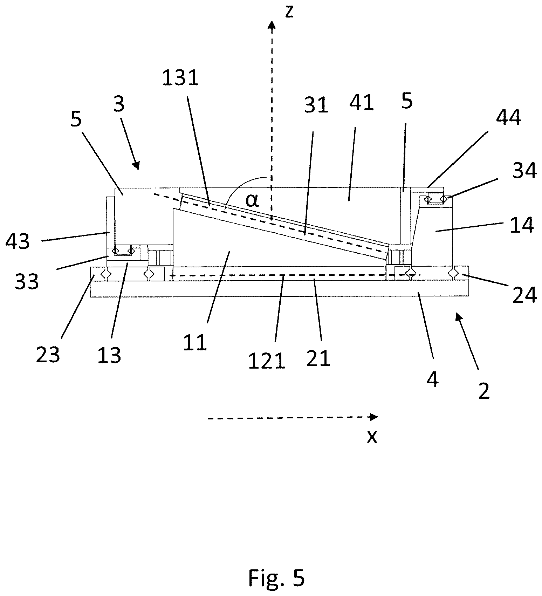

Wie insbesondere in den Fig. 3 und 5 zu erkennen ist, sind die Steiglinien 131, 132, 133, 134 und die korrespondierenden Basislinien 121, 122, 123, 124 in einer Projektion entlang der z-Achse jeweils parallel, insbesondere jeweils deckungsgleich übereinander angeordnet. Jede der vier Steiglinien und jede der korrespondierenden vier Basislinien weist bezüglich der z-Achse einen konstanten Neigungswinkel auf, wobei sich die Neigungswinkel der jeweils korrespondierenden Steig- und Basislinien unterscheidet. Im vorliegenden Ausführungsbeispiel beträgt der Neigungswinkel der Basislinien relativ zur z-Achse 90°. Demgegenüber schliessen die Steiglinien bzw. die Schrägflächen eines jeden der keilförmigen Schiebeelemente 11, 12, 13, 14 einen Neigungswinkel α von etwa 76° zur z-Achse ein. Bevorzugt sollte der Neigungswinkel α im Bereich zwischen 71° und 79° liegen.

In einer Projektion entlang der y-Achse sind die Schrägflächen der keilförmigen ersten und zweiten Schiebeelemente 11, 12 und entsprechend die erste und zweite Steig-Führungseinrichtung 31, 32 in erfindungsgemässer Weise gegenläufig zueinander geneigt orientiert. Analog sind in einer Projektion entlang der x-Achse die Schrägflächen der keilförmigen dritten und vierten Schiebeelemente 13, 14 und entsprechend die dritte und vierte Steig-Führungseinrichtung 33, 34 gemäss der Erfindung gegenläufig zueinander geneigt orientiert. Im Ergebnis wird durch die gegenläufige geneigte Anordnung der Schiebeelemente und der Steig-Führungseinrichtungen erreicht, dass eine synchrone Verschiebung des ersten und des zweiten Schiebeelements 11, 12 in entgegengesetzte Richtungen entlang der x-Achse sowie des dritten und vierten Schiebeelements 13, 14 in entgegengesetzte Richtungen entlang der y-Achse eine Verschiebung des Trägerelements 3 ausschliesslich entlang der z-Achse bewirkt. Denn aufgrund ihrer gegenläufigen Neigung sperren die erste und die zweite Steig-Führungseinrichtung 31, 32 bzw. die dritte und vierte Steig-Führungseinrichtung 33, 34 jeweils gegenseitig eine Querbewegung des Trägerelements entlang der x- bzw. y-Achse. Auf eine zusätzliche Linearführung entlang der z-Achse, die die Bewegung des Trägerelements auf die z-Achse beschränken würde, kann daher verzichtet werden.

Sämtliche Basis-Führungseinrichtungen 21, 22, 23, 24 und Steig-Führungseinrichtungen 31, 32, 33, 34 sind im vorliegenden Ausführungsbeispiel als Linearführungen mit Rollenlagern ausgebildet. Denkbar sind selbstverständlich auch andere Arten und Bauformen von Linearführungen.

Zum synchronen Verschieben der vier Schiebeelemente 11, 12, 13, 14 weist die Positioniervorrichtung 1 gemäss dem vorliegenden Ausführungsbeispiel eine gemeinsame Antriebseinrichtung für alle vier Schiebeelemente 11, 12, 13, 14 auf. Die gemeinsame Antriebseinrichtung umfasst einen Drehantrieb 9 mit einer zur z-Achse parallelen Drehachse sowie ein Koppelelement 6, wobei das Koppelelement den Drehantrieb mit dem ersten, zweiten, dritten und vierten Schiebeelement 11, 12, 13, 14 derart koppelt, dass eine Drehbewegung des Drehantriebs 9 eine synchrone Verschiebung des ersten, zweiten, dritten und vierten Schiebeelements 11, 12, 13, 14 entlang der jeweiligen Basislinien, d.h. entlang der x- bzw. y-Achse bewirkt. Hierzu weist das Koppelelement 6 einen starr mit der Drehachse verbundenen Drehkörper 7 und insgesamt vier Koppelglieder 8 auf, die bezüglich der Drehachse einen Ends an jeweils einem der Schiebeelemente 11, 12, 13, 14 und anderen Ends radial beabstandet von der Drehachse an dem Drehkörper 7 drehbar gelagert sind.

Aufgrund des gleichen Neigungswinkel der vier Steig-Führungseinrichtungen 31, 32, 33, 34 relativ zur z-Achse bewirkt die Drehung der Antriebseinrichtung um die z-Achse eine synchrone Verschiebung aller vier Schiebeelemente 11, 12, 13, 14, die wiederum das Trägerelement 3 gleichmässig entlang der z-Achse anheben. Die rechteckige bzw. quadratische Anordnung der vier Schiebeelemente zeichnet sich dabei besonders durch eine für Hochpräzisionsanwendungen hinreichend grosse Systemsteifigkeit aus.

## Patentansprüche

1. Positioniervorrichtung (1), umfassend ein Basiselement (2), ein relativ zum Basiselement (2) entlang einer z-Achse zu positionierendes Trägerelement (3) sowie wenigstens ein erstes und ein zweites Schiebeelement (11, 12), wobei das erste bzw. zweite Schiebeelement (11, 12) einerseits mittels einer ersten bzw. zweiten Basis-Führungseinrichtung (21, 22) entlang einer ersten bzw. zweiten Basislinie (121, 122) am Basiselement (2) und andererseits mittels einer ersten bzw. zweiten Steig-Führungseinrichtung (31, 32) entlang einer ersten bzw. zweiten Steiglinie (131, 132) an dem Trägerelement (3) verschiebbar angeordnet ist, wobei die erste bzw. zweite Steiglinie (131, 132) und die erste bzw. zweite Basislinie (121, 122) in Projektion entlang der z-Achse zueinander parallel und bezüglich der z-Achse mit jeweils konstanten, voneinander verschiedenen Neigungswinkeln verlaufen, wobei die erste und die zweite Steig-Führungseinrichtung (31, 32) derart zueinander angeordnet sind, dass in wenigstens einer Projektion senkrecht zur z-Achse die erste und die zweite Steiglinie (131, 132) bezüglich der z-Achse gegenläufig zueinander geneigt sind, so dass eine synchrone Verschiebung des ersten und des zweiten Schiebeelements (11, 12) relativ zum Basiselement (2) eine Verschiebung des Trägerelements (3) relativ zum Basiselement (2) ausschliesslich entlang der z-Achse bewirkt, **dadurch gekennzeichnet, dass** die Positioniervorrichtung (1) ferner ein drittes und ein viertes Schiebeelement (13, 14) aufweist, wobei das dritte bzw. vierte Schiebeelement (13, 14) einerseits mittels einer dritten bzw. vierten Basis-Führungseinrichtung (23, 24) entlang einer dritten bzw. vierten Basislinie (123, 124) am Basiselement (2) und andererseits mittels einer dritten bzw. vierten Steig-Führungseinrichtung (33, 34) entlang einer dritten bzw. vierten Steiglinie (133, 134) an dem Trägerelement (3) verschiebbar angeordnet ist, wobei die dritte bzw. vierte Steiglinie (133, 134) und die dritte bzw. vierte Basislinie (123, 124) in einer Projektion entlang der z-Achse zueinander parallel und bezüglich der z-Achse mit jeweils konstanten, voneinander verschiedenen Neigungswinkeln verlaufen, und wobei die dritte und vierte Steig-Führungseinrichtung (33, 34) derart zueinander angeordnet sind, dass in wenigstens einer Projektion senkrecht zur z-Achse die dritte und die vierte Steiglinie (133, 134) bezüglich der z-Achse gegenläufig zueinander geneigt sind, so dass eine synchrone Verschiebung des ersten, zweiten, dritten und vierten Schiebeelements (11, 12, 13, 14) relativ zum Basiselement (2) eine Verschiebung des Trägerelements (3) relativ zum Basiselement (2) ausschliesslich entlang der z-Achse bewirkt.

2. Positioniervorrichtung (1) nach Anspruch 1, **dadurch gekennzeichnet, dass** die erste und/oder zweite Basislinie (121, 122) bzw. die erste, zweite, dritte und/oder vierte Basislinie (121, 122, 123, 124) in einer Ebene senkrecht zur z-Achse verlaufen.

3. Positioniervorrichtung (1) nach Anspruch 1 oder 2, **dadurch gekennzeichnet, dass**
a. die erste und zweite Basislinie (121, 122) bzw. die erste, zweite, dritte und vierte Basislinie (121, 122, 123, 124) gleichmässig um die z-Achse verteilt angeordnet sind.
b. die erste und zweite Basislinie (121, 122) bzw. die erste, zweite, dritte und vierte Basislinie (121, 122, 123, 124) bezüglich der z-Achse achsensymmetrisch ausgebildet sind; und/oder
c. die erste und zweite Steiglinie (131, 132) bzw. die erste, zweite, dritte und vierte Steiglinie (131, 132, 133, 134) bezüglich der z-Achse achsensymmetrisch ausgebildet sind.

4. Positioniervorrichtung (1) nach einem der vorhergehenden Ansprüche, **dadurch gekennzeichnet, dass** die erste und zweite Basislinie (121, 122) Geraden sind, insbesondere parallel zueinander entlang einer zur z-Achse senkrechten x-Achse verlaufen, vorzugsweise dass die dritte und vierte Basislinie (121, 122) Geraden sind, insbesondere parallel zueinander entlang einer zur x- und z-Achse senkrechten y-Achse verlaufen.

5. Positioniervorrichtung (1) nach einem der vorhergehenden Ansprüche, **dadurch gekennzeichnet, dass**
a. die erste, zweite, dritte und/oder vierte Basis-Führungseinrichtung (21, 22, 23, 24) eine Kugellager-, Kreuzrollenlager-, Umwälzlager- oder Schwalbenschwanz-Führung aufweist; und/oder
b. die erste, zweite, dritte und/oder vierte Steig-Führungseinrichtung (31, 32, 33, 34) eine Kugellager-, Kreuzrollenlager-, Umwälzlager- oder Schwalbenschwanz-Führung aufweist.

6. Positioniervorrichtung (1) nach einem der vorhergehenden Ansprüche, **dadurch gekennzeichnet, dass** das erste, zweite, dritte und/oder vierte Schiebeelement (11, 12, 13, 14) jeweils einen Keilkörper aufweist.

7. Positioniervorrichtung (1) nach einem der vorhergehenden Ansprüche, **dadurch gekennzeichnet, dass** das Trägerelement (3) einen ersten, zweiten, dritten und/oder vierten Keilkörper (41, 42, 43, 44) aufweist, an dem jeweils die erste, zweite, dritte bzw. vierte Steig-Führungseinrichtung (31, 32, 33, 34) angeordnet ist.

8. Positioniervorrichtung (1) nach einem der vorhergehenden Ansprüche, **dadurch gekennzeichnet, dass** die erste, zweite, dritte und vierte Steiglinie (131, 132, 133, 134) zur z-Achse jeweils einen Winkel (α) zwischen 45° und 85°, insbesondere zwischen 60° und 80°, bevorzugt zwischen 71° und 79°, einschliessen.

9. Positioniervorrichtung (1) nach einem der vorhergehenden Ansprüche, **dadurch gekennzeichnet, dass** das Basiselement (2) eine Platte (4), insbesondere eine rahmenartige Platte (4) mit einer Durchgangsöffnung, aufweist.

10. Positioniervorrichtung (1) nach einem der vorhergehenden Ansprüche, **dadurch gekennzeichnet, dass** das Trägerelement (3) einen Rahmen (5), insbesondere einen rechteckigen, bevorzugt quadratischen Rahmen (5), aufweist.

11. Positioniervorrichtung (1) nach einem der vorhergehenden Ansprüche, **dadurch gekennzeichnet, dass** die erste und die zweite Steig-Führungseinrichtung (31, 32) an gegenüberliegenden Seiten des Trägerelements (3) angeordnet sind, und/oder dass die dritte und die vierte Steig-Führungseinrichtung (33, 34) an gegenüberliegenden Seiten des Trägerelements (3) angeordnet sind.

12. Positioniervorrichtung (1) nach einem der vorhergehenden Ansprüche, **dadurch gekennzeichnet, dass** die Positioniervorrichtung (1) zum synchronen Verschieben des ersten und zweiten Schiebeelements (11, 12) bzw. des erste, zweiten, dritten und vierten Schiebeelements (13, 14)
a. wenigstens eine Antriebseinrichtung (9); oder
b. jeweils eine separate Antriebseinrichtung für das erste und zweite Schiebeelement (11, 12) bzw. das erste, zweite, dritte und vierte Schiebeelement (11, 12, 13, 14) aufweist.

13. Positioniervorrichtung (1) nach Anspruch 12, **dadurch gekennzeichnet, dass** die wenigstens eine Antriebseinrichtung einen Drehantrieb (9) mit einer zur z-Achse parallelen Drehachse sowie ein Koppelelement (6) aufweist, wobei das Koppelelement (6) den Drehantrieb mit dem ersten und zweiten oder dem ersten, zweiten , dritten und vierten Schiebeelement (11, 12, 13, 14) derart koppelt, dass eine Drehbewegung des Drehantriebs eine synchrone Verschiebung des ersten und zweiten Schiebeelements (11, 12) bzw. des ersten, zweiten, dritten und vierten Schiebeelements (11, 12, 13, 14) entlang der jeweiligen Basislinien (121, 122, 123, 124) bewirkt.

14. Positionierungsvorrichtung (1) nach Anspruch 13, **dadurch gekennzeichnet, dass** das Koppelelement (6) einen starr mit der Drehachse verbundenen Drehkörper (7) und wenigstens ein Koppelglied (8) aufweist, das bezüglich der Drehachse einen Ends an einem der Schiebeelemente (11, 12, 13, 14) und anderen Ends radial beabstandet von der Drehachse an dem Drehkörper (7) drehbar gelagert ist.

## Claims

1. Positioning device (1), comprising a base element (2), a carrier element (3) to be positioned relative to the base element (2) along a z-axis as well as at least one first and one second slide element (11, 12), wherein the first or second slide element (11, 12) on the one hand is disposed displaceably by means of a first or second base guide device (21, 22) along a first or second base line (121, 122) on the base element (2) and on the other hand by means of a first or second ascent guide device (31, 32) along a first or second ascent line (131, 132) on the carrier element (3), wherein the first or second ascent line (131, 132) and the first or second base line (121, 122) run in a projection along the z-axis parallel to one another and with respectively constant different angles of inclination relative to the z-axis, wherein the first and the second ascent guide device (31, 32) are arranged with respect to one another in such a manner that in at least one projection perpendicular to the z-axis, the first and the second ascent line (131, 132) are inclined opposite to one another relative to the z-axis so that a synchronous displacement of the first and the second slide element (11, 12) relative to the base element (2) causes a displacement of the carrier element (3) relative to the base element (2) exclusively along the z-axis, **characterized in that** the
positioning device (1) further comprises a third and a fourth slide element (13, 14), wherein the third or fourth slide element (13, 14) is disposed displaceably on the one hand by means of a third or fourth base guide device (23, 24) along a third or fourth base line (123, 124) on the base element (2) and on the other hand by means of a third or fourth ascent guide device (33, 34) along a third or fourth ascent line (133, 134) on the carrier element (3), wherein the third or fourth ascent line (133, 134) and the third or fourth base line (123, 124) run parallel to one another in a projection along the z-axis and with respectively constant, different angles of inclination relative to the z-axis, and wherein the third and fourth ascent guide devices (33, 34) are disposed with respect to one another in such a manner that in at least one projection perpendicular to the z-axis, the third and the fourth ascent line (133, 134) are inclined opposite to one another relative to the z-axis so that a synchronous displacement of the first, second, third and fourth slide element (11, 12, 13, 14) relative to the base element (2) causes a displacement of the carrier element (3) relative to the base element (2) exclusively along the z-axis.

2. The positioning device (1) according to claim 1, **characterized in that** the first and/or second base line (121, 122) or the first, second, third and/or fourth base line (121, 122, 123, 124) run in a plane perpendicular to the z-axis.

3. The positioning device (1) according to claim 1 or 2, **characterized in that**
a. the first and second base line (121, 122) or the first, second, third and fourth base line (121, 122, 123, 124) are distributed uniformly about the z-axis;
b. the first and second base line (121, 122) or the first, second, third and fourth base line (121, 122, 123, 124) are configured axis-symmetrically relative to the z-axis; and/or
c. the first and second ascent line (131, 132) or the first, second, third and fourth ascent line (131, 132, 133, 134) are configured axis-symmetrically relative to the z-axis.

4. The positioning device (1) according to any one of the preceding claims, **characterized in that** the first and second base lines (121, 122) are straight lines, in particular run parallel to one another along an x-axis perpendicular to the z-axis, preferably that the third and fourth base lines (121, 122) are straight lines, in particular run parallel to one another along a y-axis perpendicular to the x- and z-axis.

5. The positioning device (1) according to any one of the preceding claims, **characterized in that**
a. the first, second, third and/or fourth base line (21, 22, 23, 24) comprises a ball bearing, crossed roller bearing, rolling bearing or dovetail guide; and/or
b. the first, second, third and/or fourth ascent guide device (31, 32, 33, 34) comprises a ball bearing, crossed roller bearing, rolling bearing or dovetail guide.

6. The positioning device (1) according to any one of the preceding claims, **characterized in that** the first, second, third and/or fourth slide element (11, 12, 13, 14) each comprises a wedge body.

7. The positioning device (1) according to any one of the preceding claims, **characterized in that** the carrier element (3) comprises a first, second, third and/or fourth wedge body (41, 42, 43, 44) on which respectively the first, second, third or fourth ascent guide device (31, 32, 33, 34) is disposed.

8. The positioning device (1) according to any one of the preceding claims, **characterized in that** the first, second, third and fourth ascent line (131, 132, 133, 134) each enclose an angle (α) between 45° and 85°, in particular between 60° and 80°, preferably between 71° and 79°, with respect to the z-axis.

9. The positioning device (1) according to any one of the preceding claims, **characterized in that** the base element (2) comprises a plate (4), in particular a frame-like plate (4) with a through opening.

10. The positioning device (1) according to any one of the preceding claims, **characterized in that** the carrier element (3) comprises a frame (5), in particular a rectangular, preferably square frame (5).

11. The positioning device (1) according to any one of the preceding claims, **characterized in that** the first and the second ascent guide device (31, 32) are disposed on opposite sides of the carrier element (3) and/or that the third and the fourth ascent guide device (33, 34) are disposed on opposite sides of the carrier element (3).

12. The positioning device (1) according to any one of the preceding claims, **characterized in that** for the synchronous displacement of the first and second slide element (11, 12) or the first, second, third and fourth slide element (13, 14) the positioning device (1) comprises
a. at least one drive device (9); or
b. respectively one separate drive device for the first and second slide element (11, 12) or the first, second, third and fourth slide element (11, 12, 13, 14).

13. The positioning device (1) according to claim 12, **characterized in that** the at least one drive device comprises a rotary drive (9) having an axis of rotation parallel to the z-axis and a coupling element (6), wherein the coupling element (6) couples the rotary drive to the first, second, third and/or fourth slide element (11, 12, 13, 14) in such a manner that a rotational movement of the rotary drive causes a synchronous displacement of the first and second displacement element (11, 12) or of the first, second, third and fourth slide element (11, 12, 13, 14) along the respective base lines (121, 122, 123, 124).

14. The positioning device (1) according to claim 13, **characterized in that** the coupling element (6) comprises a rotating body (7) connected rigidly to the axis of rotation and at least one coupling member (8) which is rotatably mounted relative to the axis of rotation with one end on one of the slide elements (11, 12, 13, 14) and the other end radially spaced apart from the axis of rotation on the rotating body (7).

## Revendications

1. Dispositif de positionnement (1), comprenant un élément de base (2), un élément porteur (3) à disposer le long d'un axe z par rapport à l'élément de base (2), de même qu'au moins un premier et un deuxième élément coulissant (11,12), le premier ou le deuxième élément coulissant (11,12) étant disposé de manière à être déplaçable d'une part au moyen d'un premier ou d'un deuxième dispositif de guidage de base (21,22) le long d'une première ou seconde ligne de base (121,122) au niveau de l'élément de base (2) et d'autre part au moyen d'un premier ou d'un deuxième dispositif de guidage d'ascension (31,32) le long d'une première ou d'une seconde ligne ascendante (131,132) au niveau de l'élément porteur (3), la première ou deuxième ligne ascendante (131,132)et la première ou deuxième ligne de base (121,122) s'étendant en projection le long de l'axe z parallèlement l'une à l'autre et par rapport à l'axe z suivant des angles d'inclinaison respectivement constants et différent l'un de l'autre, le premier et le deuxième dispositif de guidage d'ascension (31,32) étant disposés l'un par rapport à l'autre de manière à ce que, dans au moins une projection perpendiculairement à l'axe z, la première et la deuxième ligne ascendante (131,132) soient inclinées d'une part en sens inverse l'une par rapport à l'autre par rapport à l'axe z, de sorte qu'un décalage synchrone du premier et du deuxième élément coulissant (11,12) par rapport à l'élément de base (2) provoque un décalage de l'élément porteur (3) par rapport à l'élément de base (2) exclusivement le long de l'axe z, **caractérisé en ce que**
le dispositif de positionnement (1) présente en outre un troisième et un quatrième élément coulissant (13,14), le troisième ou quatrième élément coulissant (13,14) étant d'une part disposé de manière à être déplaçable au moyen d'un troisième ou quatrième dispositif de guidage de base (23,24) le long d'une troisième ou quatrième ligne de base (123,124) au niveau de l'élément de base (2) et d'autre part au moyen d'un troisième quatrième élément de guidage d'ascension (33,34) au niveau de l'élément porteur (3), la troisième ou quatrième ligne ascendante (133,134) et la troisième ou quatrième ligne de base (123,124) s'étendant dans une projection le long de l'axe z parallèlement l'une à l'autre et par rapport à l'axe z avec des angles d'inclinaison respectivement constants et différents l'un de l'autre, et les troisième et quatrième dispositifs de guidage d'ascension (33,34) étant disposés l'un par rapport à l'autre de manière à ce que, dans au moins une projection perpendiculairement à l'axe z, la troisième et quatrième ligne ascendante (133,134) soient inclinées par rapport à l'axe z en sens inverse l'une par rapport à l'autre, de sorte qu'un décalage synchrone des premier, deuxième, troisième et quatrièmes éléments coulissants (11,12,13,14) par rapport à l'élément de base (2) provoque un décalage de l'élément porteur (3) par rapport à l'élément de base (2) exclusivement le long de l'axe z.

2. Dispositif de positionnement (1) selon la revendication 1, **caractérisé en ce que** la première et/ou deuxième ligne de base (121,122) ou la première, deuxième, troisième et/ou quatrième ligne de base (121,122,123,124) s'étend dans un plan perpendiculairement à l'axe z.

3. Dispositif de positionnement (1) selon la revendication 1 ou 2, **caractérisé en ce que**
a. les première et/ou deuxième lignes de base (121,122) ou les première, deuxième, troisième et/ou quatrième lignes de base (121,122,123,124) sont disposées réparties régulièrement autour de l'axe z ;
b. les première et/ou deuxième lignes de base (121,122) ou les première, deuxième, troisième et/ou quatrième lignes de base (121,122,123,124) sont réalisées par rapport à l'axe z symétriquement à l'axe ; et/ou
c. les première et deuxième lignes ascendantes (131,132) ou les première, deuxième, troisième et/ou quatrièmes lignes ascendantes (131,132,133,134) sont réalisées par rapport à l'axe z symétriquement à l'axe.

4. Dispositif de positionnement (1) selon une des revendications précédentes, **caractérisé en ce que** les première et deuxième lignes de base (121,122) sont des droites, en particulier s'étendent parallèlement l'une à l'autre le long d'un axe x perpendiculaire à l'axe z, que, de préférence, les troisième et quatrième lignes de base (121,122) sont des droites, en particulier s'étendent parallèlement l'une à l'autre le long d'un axe y perpendiculaire à l'axe x et z.

5. Dispositif de positionnement (1) selon une des revendications précédentes, **caractérisé en ce que**
a. les premier, deuxième, troisième et/ou quatrième dispositifs de guidage de base (21,22,23,24) présentent un guide à roulement à billes, roulement à rouleaux croisés, roulement à rouleaux d'inversion, ou en queue de cygne ; et/ou
b. les premier, deuxième, troisième et/ou quatrième dispositifs de guidage d'ascension (31,32,33,34) présentent un guide à roulement à billes, roulement à rouleaux croisés, roulement à rouleaux d'inversion, ou en queue de cygne.

6. Dispositif de positionnement (1) selon une des revendications précédentes, **caractérisé en ce que** les premier, deuxième, troisième et/ou quatrième éléments coulissants (11,12,13,14) présentent respectivement un corps cunéiforme.

7. Dispositif de positionnement (1) selon une des revendications précédentes, **caractérisé en ce que** l'élément porteur (3) présente un premier, deuxième, troisième et/ou quatrième corps cunéiforme (41,42, 43,44) au niveau duquel est disposé respectivement le premier, deuxième, troisième ou quatrième dispositif de guidage d'ascension (31,32,33,34).

8. Dispositif de positionnement (1) selon une des revendications précédentes, **caractérisé en ce que** les première, deuxième, troisième et quatrième lignes ascendantes (131,132,133,134) circonscrivent par rapport à l'axe z un angle (α) compris entre 45° et 85°, en particulier entre 60° et 80°, de préférence entre 71° et 79°.

9. Dispositif de positionnement (1) selon une des revendications précédentes, **caractérisé en ce que** l'élément de base (2) présente une plaque (4), en particulier une plaque en forme de cadre (4) dotée d'un orifice traversant.

10. Dispositif de positionnement (1) selon une des revendications précédentes, **caractérisé en ce que** l'élément porteur (3) présente un cadre (5), en particulier un cadre (5) rectangulaire, de préférence quadratique.

11. Dispositif de positionnement (1) selon une des revendications précédentes, **caractérisé en ce que** les premier et deuxième éléments de guidage d'ascension (31,32) sont disposés sur des faces opposées de l'élément porteur (3),
et/ou que les troisièmes et quatrièmes éléments de guidage d'ascension (33,34) sont disposés sur des faces opposées de l'élément porteur (3).

12. Dispositif de positionnement (1) selon une des revendications précédentes, **caractérisé en ce que** le dispositif de positionnement (1), en vue du décalage synchrone des premier et deuxième éléments coulissants (11,12) ou des premier, deuxième, troisième et quatrième éléments coulissants (13,14), présente
a. au moins un dispositif d'entraînement (9) ;
b. respectivement un dispositif d'entraînement séparé pour les premier et deuxième éléments coulissants (11,12) ou les premier, deuxième, troisième et quatrième éléments coulissants (11,12,13,14).

13. Dispositif de positionnement (1) selon la revendication 12, **caractérisé en ce que** l'au moins un dispositif d'entraînement présente une commande rotative (9) dotée d'un axe parallèle à l'axe z, ainsi qu'un élément de couplage (6), l'élément de couplage (6) couplant la commande rotative aux premier, deuxième, troisième et quatrième éléments coulissants (11,12, 13,14) de manière à ce qu'un mouvement rotatif de la commande rotative provoque un décalage synchrone des premier et deuxième éléments coulissants (11,12) ou des premier, deuxième, troisième et quatrième éléments coulissants (11,12, 13,14) le long des lignes de base respectives (121,122,123,124).

14. Dispositif de positionnement (1) selon la revendication 13, **caractérisé en ce que** l'élément de couplage (6) présente un corps rotatif (7) connecté fixement à l'axe de rotation et au moins un raccord de couplage (8) qui s'appuie en rotation par rapport à l'axe de rotation d'une extrémité au niveau d'un des éléments coulissants (11,12,13,14) et de l'autre extrémité à distance radiale de l'axe de rotation au niveau du corps rotatif (7).
